# EUROPEAN PATENT APPLICATION

(11) **EP 4 307 392 A1**
(43) Date of publication of application: **17.01.2024**
(21) Application number: 22184188.5
(22) Date of filing: 11.07.2022
(51) Int. Cl.: H01L 29/808, H01L 29/778, H01L 29/167, H01L 21/337, H01L 27/07, H01L 29/16, H01L 29/20

(54) **JFET DEVICE WITH STACKED GATE CONTACT**

(71) Applicant: III-V Technologies GmbH, Wien (AT)
(72) Inventor: Raissi, Farshid, 1010 Wien (AT)
(74) Representative: Glawe, Delfs, Moll

(57) **Abstract**

It is disclosed a JFET device comprising a semiconductor layer (1), a source contact (2), a drain contact (3), a gate layer (6) and a stacked gate contact (4), wherein the stacked gate contact (4) comprises a bottom metal layer (41), a top metal layer (43) and an insulating layer (42) between the bottom and top metal layers (41, 43), wherein the source and drain contacts (2, 3) are in contact with the semiconductor layer (1), wherein the semiconductor layer (1) is doped with a first doping type and configured to provide a channel between source and drain contacts (2, 3), wherein the gate layer (6) is arranged between and in contact with the bottom metal layer (41) and the semiconductor layer (1) and is doped with a second doping type, generating a depletion region (5) in the semiconductor layer (1), and wherein the extension of the depletion region (5) into the semiconductor layer (1) is configured to be modulated by application of a voltage to the top metal layer (43), a method (100) of manufacturing a JFET device with a stacked gate contact (4) and an electrical circuit comprising a first and a second JFET device.

## Description

The invention relates to a junction field effect transistor (JFET) device comprising a semiconductor layer, a source contact, a drain contact and a stacked gate contact, to a method of manufacturing a JFET device with a stacked gate contact and to an electrical circuit, comprising a first and a second JFET device.

As electronic applications are increasingly used in all kinds of technical fields, the demand for highly efficient and versatile transistor devices is growing. Typically, such devices are based on semiconductor materials, so there is a great need for high-efficiency semiconductor-based transistor devices in particular. Increasing device speed while decreasing power consumption and noise are of growing interest as well as ease of fabrication. Reducing energy losses allows for larger integration and less power consumption in the case of digital circuits, and higher voltage and current handling in case of power devices and circuits.

Against the background of the aforementioned problems, it is therefore an object of the present invention to provide an improved JFET device.

The solution according to the invention lies in the features of the independent claims. Advantageous further embodiments are subject of the dependent claims.

According to the invention a JFET device is disclosed comprising a semiconductor layer, a source contact, a drain contact, a gate layer and a stacked gate contact, wherein the stacked gate contact comprises a bottom metal layer, a top metal layer and an insulating layer between the bottom and top metal layers, wherein the source and drain contacts are in contact with the semiconductor layer, wherein the semiconductor layer is doped with a first doping type and configured to provide a channel between source and drain contacts, wherein the gate layer is arranged between and in contact with the bottom metal layer and the semiconductor layer and is doped with a second doping type, generating a depletion region in the semiconductor layer, and wherein the extension of the depletion region into the semiconductor layer is configured to be modulated by application of a voltage to the top metal layer.

The JFET device according to the invention is for example a stacked-gate JFET with a semiconductor layer that comprises a wide-bandgap semiconductor material, preferably a material with a bandgap above 2 eV, for example silicon carbide (SiC).

The invention relates to a particularly advantageous embodiment of a JFET device, in which the electrically conductive connection between the metal gate of a JFET device and the semiconductor layer is separated by an insulating layer. This is achieved by replacing the, typically homogeneous, metal gate with a multilayer stacked gate, which comprises two metal layers insulated from each other. The bottom metal layer is designed to contact a gate layer that is inversely doped with respect to the semiconductor layer, creating a p-n junction at the interface between gate layer and semiconductor layer, and thus generating a depletion region into the semiconductor layer. Being electrically insulated from the bottom metal layer by an insulating layer, the top metal layer affects the bottom metal layer electrostatically. Application of a voltage to the top metal layer induces charges in the bottom metal layer, leading to a modulating of the depletion region within the semiconductor layer.

The inventive JFET device may be operated with gate voltages of both polarities, i.e. positive and negative voltages, wherein the polarity of the gate voltage is defined in reference to the voltage potential of the source contact. Accordingly, the stacked gate contact may operate the JFET device by application of voltages of both polarities to the top metal layer. By application of positive or negative voltages to the top metal layer, the size of the depletion region may be increased or decreased. This can be done without the fear of substantially increased gate leakage currents due to forward biasing the p-n junction between the gate layer and the semiconductor layer, because the insulating layer between the bottom and top metal layers prevents electrical current from flowing between the top metal layer and the semiconductor layer.

The polarity of the applied gate voltage may be dependent on the type of semiconductor material in the semiconductor layer. This allows to use the JFET device in numerous scenarios, for example in combining a first JFET device with a semiconductor layer having an n-type first doping type, with a second JFET device with a semiconductor layer having a p-type first doping type in an electrical circuit, e.g. on a common substrate. This way, a high versatility of the JFET device can be achieved.

The inventive JFET device allows to being used in the production of digital circuits without introducing cumbersome processing steps or hampering the superior characteristics of JFETs in terms of speed, noise and ease of fabrication.

In the following, some expressions that are used within the context of the invention are explained first:
A "stacked gate" refers to a layout of a gate of a transistor, which comprises a plurality of layers, vertically stacked on top of each other. "Vertically" means in a vertical direction that is perpendicular to the direction of the channel of the transistor, i.e. perpendicular to the direction of the current flow of the transistor between source and drain contacts. A "transistor area" is defined as the area spanned between the source contact and the drain contact, the vertical direction being normal to the transistor area.

The "first and second doping type" may be n-type or p-type. For example, the first doping type is n-type and the second doping type is p-type or vice versa. By contacting the first doping type doped semiconductor layer with the second doping type doped gate layer, a depletion region can be generated.

The semiconductor layer may be formed out of a semiconductor material that is suitable to hold a doping with at least one doping type. For instance, the semiconductor layer comprises or is constituted of elemental semiconductors, such as for example Si and Ge, and/or of compound semiconductors, in particular IV-IV semiconductor material, such as for example SiC, or III-V semiconductor material GaAs, such as for example GaN, or other families of compound semiconductors. The semiconductor layer may also comprise or be constituted of 2D materials, such as for example graphene. The semiconductor layer may be formed at least partially out of crystalline material. The semiconductor layer may provide a channel, that is electrical current may pass through the semiconductor layer between source and drain contacts, depending on the respective voltage levels applied to the source, stacked gate and drain contacts.

The bottom metal layer may comprise one or more metals and/or alloys. It can be comprised of a different sublayers itself, for example such that the contact region of the bottom metal layer with the insulating layer makes an appropriate surface for creation and/or attachment of the insulating layer. The bottom metal layer may be configured to provide an Ohmic contact, i.e. a non-rectifying contact, to the gate layer.

For example, in case of the semiconductor layer comprising or being constituted of Si or GaAs, the bottom metal layer may for example comprise or be constituted of Al or Au based alloys.

The gate layer is arranged between and in contact with the bottom metal layer and the semiconductor layer. In an embodiment, one or more additional layers and/or films, e.g. an insulating film, may be arranged between the gate layer and the semiconductor layer, wherein for example the areal extension of the one or more further layers and/or films along the transistor area is less than the areal extension of the gate layer along the transistor area. The gate layer may be formed as an individual component of the device. For example, the gate layer is separated from the semiconductor layer. The gate layer may be formed out of a semiconductor material, for example a semiconductor material that is different to the semiconductor material of the semiconductor layer. This allows for designing the gate functionality of the JFET device independently from the semiconductor layer material. As gate layer material accordingly doped polycrystalline silicon may for instance be used. To the alternative, the gate layer may be comprised by the semiconductor layer. For example, the gate layer is formed as a region of the semiconductor layer that is doped inversely with respect to the semiconductor layer. This can avoid the necessary provision of the gate layer in a separate process step, such as e.g. additional material deposition, and may thus facilitate the manufacturing of the device.

The top metal layer may also comprise one or more metals and/or alloys and can also be comprised of a different sublayers itself. For example, the top metal layer may be designed in order to show a particularly low resistance. For example, the top metal layer may comprise Au. Exemplarily, the material of the bottom metal layer is different to material of the top metal layer.

The insulating layer can be created by allowing the top surface of the bottom metal layer to form an insulating material. For example, by applying a gas inside a vacuum chamber or via chemical processes, e.g. by oxidization. It is likewise possible that the insulating layer is formed via the deposition of an insulating material, e.g. by chemical or physical deposition. It is also possible that the insulating layer comprises different materials and/or different layers, for example an oxide layer and a nitride layer. For example, the insulating layer may comprise at least two sublayers of different materials.

According to an embodiment of the JFET device, the top metal layer comprises a first area and a second area, wherein the first and second areas are electrically separated from each other, and wherein the extension of the depletion region into the semiconductor layer is configured to be modulated by application of a voltage to at least one of the first area and the second area.

This configuration allows for a "decoupled-input" design of the stacked gate. A first voltage may be applied to the first area such that a specific extension of the depletion region into the semiconductor layer is set. The stacked gate as a whole is then driven by applying a second voltage to the second area, such that the extension of the depletion region as set by the application of the first voltage can be modulated, wherein e.g. the second voltage is of the opposite polarity compared to the first voltage. Such a configuration enables particularly precise control of the transistor and also at especially low currents.

Additionally, the stacked gate contact may be configured to have a first voltage applied to the first area to extend the depletion region to pinch off the channel in the semiconductor layer, and to have a second voltage applied to the second area to modulate the extension of the depletion region into the semiconductor layer.

With such a configuration, the device may be set to off-state by applying an appropriate first voltage ("blocking voltage"), whereas the channel can be opened by modulating the extension of the depletion region via application of the second voltage. This enables to use the device comparably to a normally-off device. Being biased with the first voltage and without application of the second voltage, the channel is pinched off. The biased device is in off-state and can be operated by application of the second voltage - without having to change the first voltage. Also, in case of failure of the device-driving second voltage, the device will turn to off-state, which increases its fail-safe operation ability.

Preferably, the semiconductor layer comprises a source region contacting the source contact and a drain region contacting the drain contact, wherein the doping concentration of the first doping type is higher inside the source region and/or the drain region than outside the source region and/or the drain region.

By increasing the concentration of the doping in the source region with respect to the doping concentration outside of the source region, the Ohmic contact resistance of the source contact can be reduced. Likewise, the Ohmic contact resistance of the drain contact can be reduced by increasing the concentration of the doping in the drain region with respect to the doping concentration outside of the drain region. This allows for a higher efficiency of the device. Also, a higher doping concentration allows for the usage of one type of metal contact to obtain Ohmic contacts to both n- and p-type semiconductor layers.

Advantageously, the bottom metal layer is arranged to be electrically connected, preferably externally. This allows for individually setting a voltage level of the bottom metal layer, so the characteristics of the device can be tuned in a particularly flexible manner.

In another embodiment the JFET device, the thickness of the insulating layer is designed to limit leakage current between the bottom metal layer and the top metal layer in on-state to less than 4000 A/cm², preferably to less than 1000 A/cm2, more preferably to less than 100 A/cm².

Thus, the thickness of the insulating layer is to be designed as a tradeoff between two opposing aspects. The first aspect is the amount of leakage current to be allowed, and the second is the desire to control the extension of the depletion region as extensively as possible by application of a voltage to the top metal layer. In the sense of the first aspect, the thickness of the insulating layer should be as great as possible, whereas the second aspect requires the smallest possible thickness. Also, the dielectric constant of the material (or the material layers) used within the insulating layer has an impact on the leakage current between the bottom metal layer and the top metal layer in on-state. With a larger dielectric constant the control over the depletion region can be more direct and to a larger extent. Also a material with larger dielectric constant allows for less leakage current for a given thickness. Thus, for a given material of the insulating layer, the thickness of the insulating layer is to be designed depending on the dielectric constant of the material. The higher the dielectric constant, the lower may the thickness be designed in order to achieve the required limits of leakage current values. Exemplary materials of the insulating layer comprise Si₃N₄, Al₂O₃, ZrO₂, HfO₂, La₂O₃, Ra₂O₃ and TiO₂. The dielectric constant of these materials increases from Si₃N₄ to TiO₂ in order of their nomination. Al₂O₃, ZrO₂, HfO₂ and TiO₂ allow for a particularly easy and reliable deposition on top of the bottom metal gate. For example, the thickness of an insulating layer comprising at least one of Al₂O₃, ZrO₂, HfO₂ and TiO₂ may be 60 nm limiting the leakage current between the bottom metal layer and the top metal layer in on-state to less than 4000 A/cm², and may be 110 nm limiting the leakage current between the bottom metal layer and the top metal layer in on-state to less than 100 A/cm².

In accordance with the invention, there is also disclosed a method of manufacturing a JFET device with a stacked gate contact according the invention, comprising: providing a semiconductor layer, wherein the semiconductor layer is doped with a first doping type; providing a gate layer being in contact with the semiconductor layer, wherein the gate layer is doped with a second doping type, generating a depletion region in the semiconductor layer; applying a bottom metal layer onto the gate layer; applying an insulating layer onto the bottom metal layer; applying a top metal layer onto the insulating layer, wherein the extension of the depletion region into the semiconductor layer is configured to be modulated by application of a voltage to the top metal layer; and applying a source contact and a drain contact onto the semiconductor layer.

Preferably, the insulating layer and the top metal layer are applied in-situ.

An in-situ application of different layers is to be understood as deposition of one layer after another without the possibility for contamination of the contact area of the layers, for example without breaking of the vacuum in one process environment (e.g. deposition of layers within one vacuum chamber without venting). This allows for a particularly defect-free constitution of the stacked gate.

According to an embodiment, the method step of providing a gate layer comprises: depositing an insulating film onto the semiconductor layer; opening the insulating film for defining a gate area of the contact of the gate layer with the semiconductor layer; and depositing a gate layer material, such as polycrystalline silicon, onto the semiconductor layer in the gate area.

Additionally, the insulating film may be opened for defining areas of source and drain regions of the semiconductor layer. This allows to provide a specific doping for the source and drain regions. For example, a doping of the source and/or drain region may be provided with the first doping type of a concentration that is higher than the concentration of doping with the first doping type in the semiconductor layer outside the source and/or drain region.

In a further embodiment, the step of applying a bottom metal layer comprises: depositing a protective layer; opening the protective layer for defining a stack area of the contact of the bottom metal layer with the gate layer; and depositing a bottom metal layer material onto the gate layer in the stack area.

Preferably, the step of applying a source contact and a drain contact may comprise: opening the insulating film and/or the protective layer for defining a source area of the source contact and a drain area of the drain contact; and depositing source and drain materials onto the semiconductor layer in the source and drain areas.

Accordingly providing the gate layer, the bottom metal layer and/or applying source and drain contacts allows to make the respective processing step compatible with current CMOS technology. CMOS-compatibility of the method of manufacturing a JFET device with a stacked gate contact may be achieved when considering both said steps. The insulating film may for example be a silicon nitride (Si₃N₄) film. The protective layer may be a silicon oxide (SiO₂) layer. The protective layer may serve as a physical protection and an electrical passivation of the JFET device. The thickness of the protective layer may be larger, for example at least 5 times, at least 10 times or at least 50 times, than the thickness of the insulating film.

Furthermore, an electrical circuit according to the invention is disclosed, comprising a first JFET device according to the invention, wherein the first doping type is n-type, and wherein the second doping type is p-type; and a second JFET device according to the invention, wherein the first doping type is p-type, and wherein the second doping type is n-type.

Such an electrical circuit may for instance be built on a common substrate and be compatible with current CMOS technology.

In an embodiment of the electrical circuit, the drain contact of the first JFET device and the source contact of the second JFET device are electrically connected, wherein the top metal layer of the first JFET device and the top metal layer of the second JFET device are electrically connected, and wherein the extension of the depletion region into the semiconductor layer in the first JFET device and the extension of the depletion region into the semiconductor layer in the second JFET device is configured to be modulated by application of a voltage to one of the top metal layers.

This configuration allows for provision of a digital NOT gate, which can also be used as an inverter amplifier, in which the leakage current between top metal layer and the semiconductor layer in the first and second JFET device is significantly reduced. The described electrical circuit can also be used in any amplifying circuit such as input or output of operational amplifiers, current mirrors, current sinks or sources.

It is to be understood that the presentation of the invention in this section is merely by way of examples and non-limiting.

The invention is explained in more detail below by way of examples in conjunction with the accompanying drawings, showing advantageous embodiments.

In the figures show:
- Figure 1: a schematic representation of a first embodiment of a JFET device according to the invention;
- Figure 2: a schematic representation of a second embodiment of a JFET device according to the invention;
- Figure 3: a schematic representation of an embodiment of an electric circuit according to the invention;
- Figure 4: a schematic flow diagram of an embodiment of a method according to the invention;
- Figure 5: a first output characteristic of a JFET device according to the invention;
- Figure 6: a second output characteristic of a JFET device according to the invention; and
- Figure 7: a third output characteristic of a JFET device according to the invention.

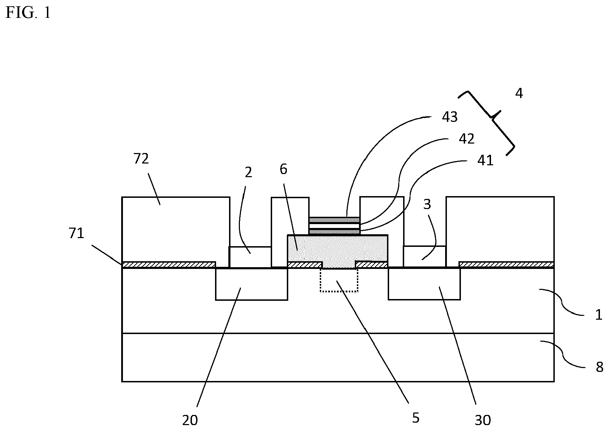

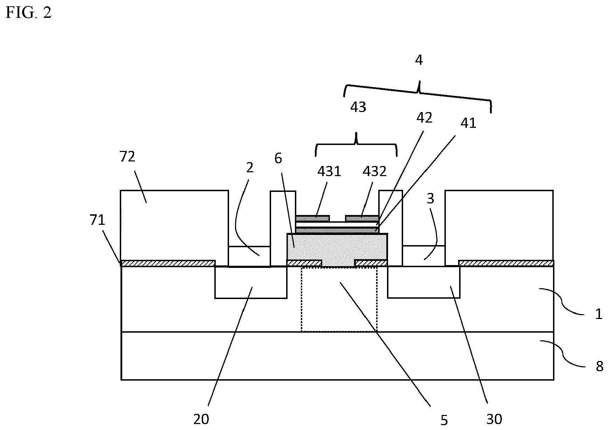

Figs. 1 and 2 show first and second embodiments of a JFET device, which comprises a semiconductor layer 1, a source contact 2, a drain contact 3, a stacked gate contact 4 and a gate layer 6. Electrical current may pass from the source contact 2 to the drain contact 3 through the semiconductor layer 1, depending on the respective voltage levels applied to the source, stacked gate and drain contacts.

The semiconductor layer 1 is n-type doped, while the gate layer 6 is formed out of p-type doped semiconductor material. A channel is provided in the semiconductor layer 1 between the source contact 2 and the drain contact 3. The semiconductor layer 1 comprises a source region 20 and a drain region 30, which both are n+-doped. In the contact region between the gate layer 6 and the semiconductor layer 1 a depletion region 5 is generated that extends into the semiconductor layer 1.

Also indicated is a Si₃N₄ insulating film 71 covering parts of the semiconductor layer 1 as a passivation. A SiO₂ protective layer 72 covers the insulating film 71 as well as parts of the semiconductor layer 1 and the gate layer 6.

As illustrated in Figs. 1 and 2, as long as the depletion region 5 does not extend along the entire (vertical) thickness of the semiconductor layer 1, the channel will be provided, that is charges may flow between source contact 2 and drain contact 3, and not pinched off, that is charge flow between source contact 2 and drain contact 3 is prohibited.

Each of the source contact 2, the drain contact 3 and the gate layer 6 is in contact with the semiconductor layer 1. The stacked gate contact 4 is in contact with the gate layer 6.

The stacked gate contact 4 comprises a bottom metal layer 41, a top metal layer 43 and an insulating layer 42. The insulating layer 42 is situated between the bottom metal layer 41 and top metal layer 43. Accordingly, the stacked gate contact 4 has a sandwich structure, in which the insulating layer 42 lies between the bottom and top metal layers 41 and 43. The bottom metal layer 41 is in contact with the gate layer 6. In such a stacked gate contact 4, application of negative voltage to the top metal layer 43 results in the accumulation of positive charges in the contact region of the bottom metal layer 41 with the insulating layer 42 and negative charges in the contact region of the bottom metal layer 41 with the gate layer 6. Accordingly, application of positive voltage to the top metal layer 43 leads to the accumulation of positive charges in the contact region of the bottom metal layer 41 with the gate layer 6. Due to the insulating layer 42, there will however no leakage current be flowing between the top metal layer 43 and the bottom metal layer 41.

When negative charges are accumulated in the contact region of the bottom metal layer 41 with the gate layer 6, this amounts to reverse biasing the p-n junction between gate layer 6 and semiconductor layer 1. This leads to a decrease of the extension of the depletion region 5. Correspondingly, when positive charges are accumulated in the contact region of the bottom metal layer 41 with the gate layer 6, this amounts to reverse biasing the p-n junction between gate layer 6 and semiconductor layer 1, which leads to an increase of the extension of the depletion region 5. Accordingly, the extension of the depletion region 5 into the semiconductor layer 1 can be modulated by application of a voltage to the top metal layer 43.

The JFET device is embodied on top of a substrate 8, which may be for example out of SiO₂, SiC or semi-insulating GaAs.

The device according to the embodiment of Fig. 2 corresponds to the one of Fig. 1, with the difference that the top metal layer 43 comprises a first area 431 and a second area 432, which areas are electrically separated from each other. The extension of the depletion region 5 into the semiconductor layer 1 can be modulated by applying a voltage to any one of the first area 431 and second area 432.

Such a configuration allows for inducing charges in the bottom metal layer 41 by voltage biasing the first area 431 such that the depletion region 5, as indicated in Fig. 2, is generated to an extent that the channel in the semiconductor layer 1 is pinched off ("blocking voltage"). The flow of charge carriers between source contact 2 and drain contact 3 is prohibited, electrical current cannot pass between source contact 2 and drain contact 3. Thus, the JFET device is set to off-state.

The second area 432 can then be used as an input for voltage biasing the bottom metal layer 41 to modulate the extension of the depletion region 5, i.e. to reduce the extension of the depletion region 5 caused by the blocking voltage biasing applied to the first area 431. This way, the blocked channel in the semiconductor layer 1 can be opened. The device may generally set to off-state by application of the blocking voltage to the first area 431 and can be operated by application of the second voltage to the second area 432.

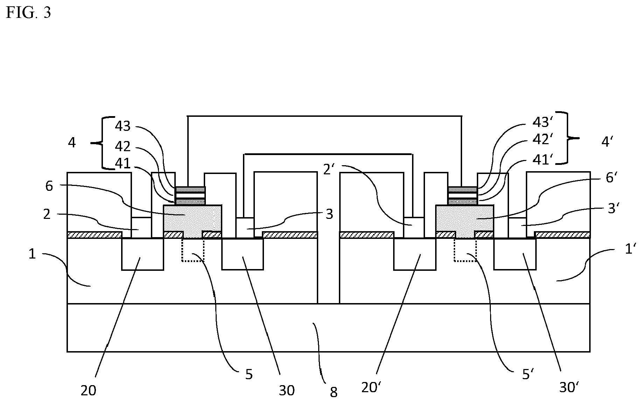

An embodiment of an electrical circuit according to the invention is presented in Fig. 3. It shows two JFET devices as described above, each comprising a semiconductor layer 1, 1', a source contact 2, 2', a drain contact 3, 3', a stacked gate contact 4, 4', a gate layer 6, 6' and a depletion region 5, 5'. Each of the stacked gate contacts 4, 4' comprises a bottom metal layer 41, 41' and a top metal layer 43, 43' with an insulating layer 42, 42' situated between the bottom metal layer 41, 41' and the top metal layer 43, 43'. Both devices are built on a common substrate 8.

The difference between the two devices is that the first doping type of the semiconductor layer 1 of the first device is n-type, whereas the first doping type of the semiconductor layer 1' of the second device is p-type. Accordingly, the doping in the source region 20 and drain region 30 of the first device is n-type of a higher concentration (n+-type), whereas the doping in the source region 20' and drain region 30' of the second device (not shown) is p-type of a higher concentration (p+-type). Further accordingly, the second doping type of the gate layer 6 of the first device is p-type, whereas the second doping type of the gate layer 6' of the second device is n-type.

This configuration allows for a CMOS-compatible provision of a digital NOT gate, which can also be used as an inverter amplifier. Because the input terminal is attached to top metal layer 43, 43' of the stacked gate contacts 4, 4', which is isolated from the respective bottom metal layer 41, 41' and the semiconductor 1, 1', the input can take both polarities of voltage without the fear of forward biasing the stacked gate contact. The exemplary electrical circuit can also be used in any amplifying circuit such as input or output of operational amplifiers, current mirrors, current sinks or sources.

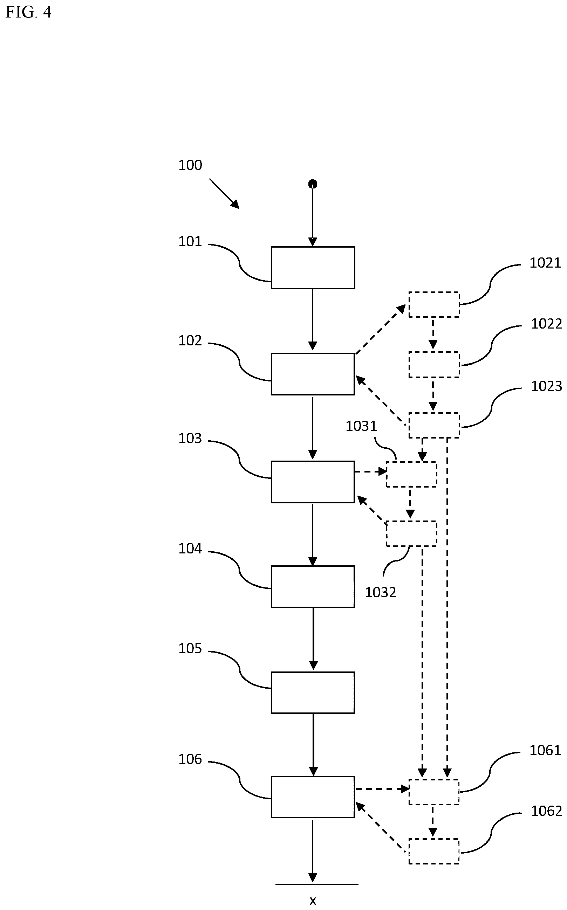

Fig. 4 shows a flow diagram of an embodiment of a method 100 according to the invention for manufacturing a JFET device with a stacked gate contact.

In method step 101, a semiconductor layer 1 is provided. The semiconductor layer 1 is doped with a first doping type.

Method step 102 comprises the provision of a gate layer 6 that is in contact with the semiconductor layer 1. The gate layer 6 is doped with a second doping type. This leads to the generation of a depletion region 5 in the semiconductor layer 1.

The provision of the gate layer 6 according to step 102 may optionally comprise the method steps 1021, 1022 and 1023.

In step 1021, an insulating film 71 is deposited onto the semiconductor layer 1. The insulating film 71 is for example a Si₃N₄ film. This insulating film 71 is opened in step 1022 for defining a gate area of the contact of the gate layer 6 with the semiconductor layer 1. In a step 1023, a gate layer material, such as accordingly doped polycrystalline silicon, is deposited onto the semiconductor layer 1 in the gate area.

Optionally, step 102 may further comprise opening of the insulating film 71 to allow for defining areas of the source region 20 and of the drain region 30. After such defining, impurities may be intentionally introduced into the semiconductor layer 1 in said areas to achieve an increase in the doping concentration in the source region 20 and the drain region 30.

A bottom metal layer 41 is applied onto the gate layer 6 in step 103. This may be done for instance by a deposition of bottom metal material in an evaporation process and/or by sputtering.

The step 103 of applying a bottom metal layer 41 may comprise the optional method steps 1031, 1032 and 1033.

In step 1031 a protective layer 72, such as a SiO₂ layer, is deposited, for example onto the insulating film 71, onto parts of the semiconductor layer 1 and/or onto parts of the gate layer 6. The protective layer 72 is opened in step 1032 for defining a stack area of the contact of the bottom metal layer 41 with the gate layer 6. In a step 1033, a bottom metal layer material, is deposited onto the gate layer 6 in the stack area.

Method step 104 comprises applying an insulating layer 42 onto the bottom metal layer 41. Depending on the material of the insulating layer 42 this may be performed for instance by Plasma Enhanced Chemical Vapor Deposition (PECVD) for example in the case of nitrides, or Atomic Layer Deposition (ALD) for example in the case of oxides such as HfO₂. Also, a chemical treatment of the deposited bottom metal layer 41, such as Plasma Oxidation, is possible in order to achieve the application of the insulating layer 42, for example in the case of TiO₂.

In step 105 a top metal layer 43 is applied onto the insulating layer 42. Similar to the bottom metal layer, deposition of the top metal layer 43 may be exemplarily done in an evaporation process and/or by sputtering. If the insulating layer 42 and the top metal layer 43 are to be applied in-situ, an appropriate processing means has to be chosen in order to being able to deposit the insulating (non-conducting) layer 42 as well as the (conducting) top metal layer 43. For example, this can be achieved in an ALD system.

In step 106, a source contact 2 and a drain contact 3 are applied onto the semiconductor layer 1, which may be performed analog to the application of the bottom metal layer 41.

In case of step 102 comprising method steps 1021, 1022 and 1023 or in case of step 103 comprising method steps 1031, 1032 and 1033, the step 106 may additionally comprise the method steps 1061 and 1062.

In step 1061, similar to steps 1022 and 1032, the insulating film 71 and/or the protective layer 72 is opened for defining a source area of the source contact 2 and a drain area of the drain contact 3. In a step 1062, source and drain materials are deposited onto the semiconductor layer 1 in the source and drain areas. This may be done for instance by deposition of a metal that makes Ohmic contact to the semiconductor layer, e.g. in the source and drain regions, in an evaporation process and/or by sputtering.

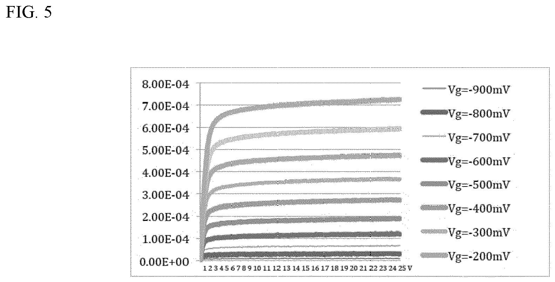

Fig. 5, 6 and 7 show output characteristics of a JFET device according to the invention, for which the first doping type (of the semiconductor layer 1) is n-type and the second doping type (of the gate layer 6) is p-type.

In each of Figs. 5, 6 and 7 the X-axis shows the drain voltage (in V) that is passed through for different gate voltages Vg. The level of the respective gate voltage (in mV) is indicated on the right-hand side. The gate voltage corresponds to the voltage applied to the top metal layer 43 of the stacked gate 4. The source voltage is set to zero. The Y-axis represents the respective measured drain current in mA.

In Fig. 5, it can be seen that the device is in off-state at a gate voltage of -900 mV, but as the gate voltage increases, the channel opens. With increasing gate voltage, the achievable drain current increases as well. This shows that the stacked gate proposal has not changed the usual operation of the JFET.

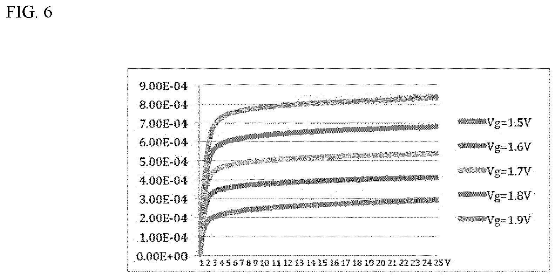

The second output characteristic of Fig. 6 represents a continuation of the one of Fig. 5 with positive gate voltages being applied. It is observable that the device provides stable operation and does not suffer from breakdown or increased forward leakage. Accordingly, the device can be successfully operated with voltages of both polarities applied to the top metal layer 43.

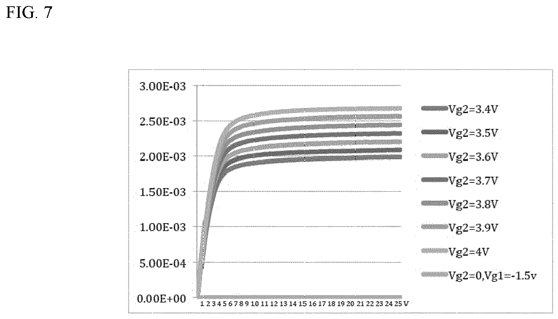

The third output characteristic according to Fig. 7 has been determined by means of a JFET device with a "decoupled-input" design, in which the top metal layer 43 comprises a first area 431 and a second area 432. A first gate voltage applied to the first area 431, Vg1, is held at -1.5 V. By application of a second gate voltage to the second area 432, Vg2, of 0 V, the resulting voltage applied to the top metal layer 43 is below the pinch-off voltage, thus the device is set to off-state. However, while the first voltage is kept at -1.5 V, the device may be set to on-state by applying a second gate voltage such that the resulting voltage applied to the top metal layer 43 is above the pinch-off voltage. This is shown in Fig. 7 for individual exemplary second gate voltages between 3.4 V and 4 V. This demonstrates successful operation of the device with voltages of both polarities applied to the first area 431 and the second area 432 of the top metal layer 43.

The embodiments of the invention described in this specification and the optional features and characteristics indicated in each case with respect thereto shall also be understood as disclosed in all combinations with each other. In particular, the description of a feature encompassed by an embodiment - unless explicitly stated to the contrary - shall also not be understood herein as meaning that the feature is indispensable or essential for the embodiment.

## Claims

1. JFET device comprising a semiconductor layer (1), a source contact (2), a drain contact (3), a gate layer (6) and a stacked gate contact (4),
wherein the stacked gate contact (4) comprises a bottom metal layer (41), a top metal layer (43) and an insulating layer (42) between the bottom and top metal layers (41, 43),
wherein the source and drain contacts (2, 3) are in contact with the semiconductor layer (1),
wherein the semiconductor layer (1) is doped with a first doping type and configured to provide a channel between source and drain contacts (2, 3),
wherein the gate layer (6) is arranged between and in contact with the bottom metal layer (41) and the semiconductor layer (1) and is doped with a second doping type, generating a depletion region (5) in the semiconductor layer (1), and
wherein the extension of the depletion region (5) into the semiconductor layer (1) is configured to be modulated by application of a voltage to the top metal layer (43).

2. JFET device according to claim 1, wherein the top metal layer (43) comprises a first area (431) and a second area (432), wherein the first and second areas (431, 432) are electrically separated from each other, and wherein the extension of the depletion region (5) into the semiconductor layer (1) is configured to be modulated by application of a voltage to at least one of the first area (431) and the second area (432).

3. JFET device according to claim 2, wherein the stacked gate contact (4) is configured to have a first voltage applied to the first area (431) to extend the depletion region (5) to pinch off the channel in the semiconductor layer (1), and to have a second voltage applied to the second area (432) to modulate the extension of the depletion region (5) into the semiconductor layer (1).

4. JFET device according to any one of the preceding claims, wherein the gate layer (6) is separate from the semiconductor layer (1).

5. JFET device according to any one of the preceding claims, wherein the insulating layer (42) comprises at least two sublayers of different materials.

6. JFET device according to any one of the preceding claims, wherein the bottom metal layer (41) is arranged to be electrically connected, preferably externally.

7. JFET device according to any one of the preceding claims, wherein the thickness of the insulating layer (42) is designed to limit leakage current between the bottom metal layer (41) and the top metal layer (43) in on-state to less than 4000 A/cm², preferably to less than 1000 A/cm², more preferably to less than 100 A/cm².

8. Method (100) of manufacturing a JFET device with a stacked gate contact (4) according to any one of the preceding claims, comprising:
- providing (101) a semiconductor layer (1), wherein the semiconductor layer (1) is doped with a first doping type;
- providing (102) a gate layer (6) being in contact with the semiconductor layer (1), wherein the gate layer (6) is doped with a second doping type, generating a depletion region (5) in the semiconductor layer (1);
- applying (103) a bottom metal layer (41) onto the gate layer (6);
- applying (104) an insulating layer (42) onto the bottom metal layer (41);
- applying (105) a top metal layer (43) onto the insulating layer (42), wherein the extension of the depletion region (5) into the semiconductor layer (1) is configured to be modulated by application of a voltage to the top metal layer (43); and
- applying (103) a source contact (2) and a drain contact (3) onto the semiconductor layer (1).

9. Method (100) according to claim 8, wherein the insulating layer (42) and the top metal layer (43) are applied in-situ.

10. Method (100) according to any of claims 8 to 9, wherein the step of providing (102) a gate layer (6) comprises:
- depositing (1021) an insulating film (71) onto the semiconductor layer (1);
- opening (1022) the insulating film (71) for defining a gate area of the contact of the gate layer (6) with the semiconductor layer (1); and
- depositing (1023) a gate layer material onto the semiconductor layer (1) in the gate area.

11. Method (100) according to any of claims 8 to 10, wherein the step of applying (103) a bottom metal layer (41) comprises:
- depositing (1031) a protective layer (72);
- opening (1032) the protective layer (72) for defining a stack area of the contact of the bottom metal layer (41) with the gate layer (6); and
- depositing (1033) a bottom metal layer material onto the gate layer (6) in the stack area.

12. Method (100) according to any of claims 10 to 11, wherein the step of applying (106) a source contact (2) and a drain contact (3) comprises:
- opening (1061) the insulating film (71) and/or the protective layer (72) for defining a source area of the source contact (2) and a drain area of the drain contact (3); and
- depositing (1062) source and drain materials onto the semiconductor layer (1) in the source and drain areas.

13. Electrical circuit, comprising:
- a first JFET device according to any of claims 1 to 7, wherein the first doping type is n-type, and wherein the second doping type is p-type; and
- a second JFET device according to any of claims 1 to 7, wherein the first doping type is p-type, and wherein the second doping type is n-type.

14. Electrical circuit according to claim 13,
wherein the drain contact (3) of the first JFET device and the source contact (2') of the second JFET device are electrically connected,
wherein the top metal layer (43) of the first JFET device and the top metal layer (43') of the second JFET device are electrically connected, and
wherein the extension of the depletion region (5) into the semiconductor layer (1) of the first JFET device and the extension of the depletion region (5') into the semiconductor layer (1') of the second JFET device is configured to be modulated by application of a voltage to one of the top metal layers (43, 43').
